Europäisches Patentamt

European Patent Office

Office européen des brevets

(19)

(11) **EP 0 642 170 B1**

(12) **EUROPEAN PATENT SPECIFICATION**

(45) Date of publication and mention
of the grant of the patent:
**03.12.1997 Bulletin 1997/49**

(51) Int Cl.6: **H01L 29/10**, H01L 29/735,
H01L 29/737

(21) Application number: **94203106.3**

(22) Date of filing: **21.02.1991**

(54) **Lateral bipolar transistor**

Lateraler Bipolartransistor

Transistor bipolaire latéral

(84) Designated Contracting States:
**DE FR GB IT NL**

(30) Priority: **22.02.1990 JP 42066/90**
**22.02.1990 JP 42067/90**
**22.02.1990 JP 42068/90**

(43) Date of publication of application:
**08.03.1995 Bulletin 1995/10**

(62) Document number(s) of the earlier application(s) in
accordance with Art. 76 EPC:
**91301383.5 / 0 443 852**

(73) Proprietor: **CANON KABUSHIKI KAISHA**
**Tokyo (JP)**

(72) Inventor: **Morishita, Masakazu,**
**c/o Canon Kabushiki Kaisha**
**Ohta-ku, Tokyo (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
- **IEEE TRANSACTIONS ON ELECTRON DEVICES,**
**vol.36, no.10, October 1989 pages 2156 - 2164,**
**XP95528 R.L. THORNTON ET AL.**
- **1989 SYPOSIUM ON VLSI TECHNOLOGY, May**
**1989 pages 95 - 96 G.L. PATTON ET AL.**
- **IEEE TRANSACTIONS ON ELECTRON DEVICES,**
**vol.ED-32, no.7, July 1985 pages 1307 - 1313 P.**
**VAN HALEN ET AL.**
- **INTRODUCTION TO SOLID STATE PHYSICS, 3rd**
**EDITION, KITTEL, J.WILEY & SONS, 1967, page**
**302**

## Description

The present invention relates to a lateral bipolar transistor.

There is already known a lateral bipolar transistor in which the current flows horizontally, namely parallel to the surface of the substrate. Such lateral bipolar transistor is widely used because of the advantage that it can be easily compatible with a vertical bipolar transistor in which the current flows vertically, namely in the direction of depth of the substrate. For example, a horizontal bipolar transistor of pnp structure can be loaded on the same substrate as a vertical bipolar transistor of opposite npn structure.

However, the conventional lateral bipolar transistor has been associated with a drawback that the current amplification factor $h_{FE}$ cannot be increased because of the following reasons.

This is due to facts that, because of a low emitter-collector breakdown voltage resulting from symmetrical arrangement of the emitter region and the collector region in such lateral bipolar transistor, the base width is apt to be influenced by the collector voltage resulting eventually in so-called Early effect (spreading of depletion layer), and that, because of wide internal spreading of the current flowing from the emitter into the base, the recombined current in the base region governs the function and the increased base current reduces significantly the current amplification factor $h_{FE}$.

In consideration of the foregoing, the present invention is intended to increase the current amplification factor of a lateral bipolar transistor.

This problem has also been addressed by R.L. Thornton et al : IEEE Transaction on Electron Devices, 36, No. 10., (1989) pages 2156-2164. Common features of the lateral bipolar transistor disclosed therein are recited in the preamble of the main claim appended hereto. The transistor disclosed, however, has a laminated structure comprising layers of AlGaAs and GaAs. Impurity-induced disordering via silicon diffusion is used to selectively convert a buried p-type GaAs layer into n-type AlGaAs regions that serve as the emitter and collector of the transistor. The active base layer, which is of narrower band gap GaAs, is completely submerged beneath the surface and therefore is not susceptible to device performance degradation due to surface recombination. The emitter and collector contacts are of Cr-Au. The high Si doping level in the Si diffused regions is relied upon to make ohmic contact to the emitter and collector.

The lateral bipolar transistor of the present invention is characterised by:

an ultra thin film insulating layer for passing a tunnel current, which insulating layer is on the surface of said emitter region; and
a polycrystalline emitter contact layer on said insulating layer; wherein
at the junction of said contact layer, insulating layer, and emitter region, the energy band gap of said polycrystalline emitter contact layer is wider than the energy band gap of said emitter region.

Since at the tunnelling junction the energy band gap of the contact layer is wider than the energy band gap of the emitter region, the tunnelling of minority carriers from the emitter region to the emitter contact layer is impeded. The current amplification factor is therefore improved.

It is acknowledged that tunnel junction emitter contacts are known. P. van Halen et al: IEEE Transactions on Electron Devices ED-32 No.7 (1985) pages 1307-1313 have disclosed high-gain bipolar transistors with polysilicon tunnel junction emitter contacts. In the transistor described, the emitter is of monocrystalline silicon and the emitter contact is of polycrystalline silicon. An emitter contact having a wider energy band gap than the emitter region is not disclosed. In the preferred embodiments discussed hereinbelow, silicon and silicon-germanium alloy materials are used. It is acknowledged that, in general, the use of such materials in transistor construction is known, see for example G.L. Patton et al: 1989 Symposium on VLSI Technology, May 22 (1989), pages 95-96.

Lateral bipolar transistors embodying the invention according to claim 1 have an emitter region and a collector region of a first conductive type and a base region of a second conductive type, a potential barrier formed in at least a part of said base region and functioning in the direction of depth to impede minority carriers injected from said emitter region to said base region, a thin film formed on said emitter region for passing a tunnel current, and a polycrystalline layer formed on said thin film and having a wider energy band gap than the material of said emitter region adjacent to said thin film.

A heterogeneous junction may be formed in the base region to constitute the potential barrier, functioning to prevent minority carriers injected from the emitter area from diffusion into the interior of the substrate and thus increasing the current amplification factor $h_{FE}$ of the lateral bipolar transistor.

Said potential barrier can be rendered sufficiently effective even at room temperature, by selecting the magnitude of potential of said barrier at least equal to the corresponding thermal energy KT at the desired temperature T.

Furthermore, a potential barrier consisting for example of a heterogeneous junction may be formed at the interface of the emitter and base regions so as to be effective against minority carriers in the base area, thereby preventing emitter current from diffusion into the interior of the substrate, and preventing an increase in the current resulting from recombination of the minority carriers with majority carriers in the base region. The heterogeneous junction is also provided on the emitter region to reduce the current component injected from the base region into the emitter region, whereby an increase in the current amplification factor of the lateral bipolar transistor can be realised.

Provided the depth of said emitter region is made at least shorter than the diffusion length of the minority carriers of the emitter region injected from said base region, a component of the base current, namely the diffusion of the minority carriers of the emitter region, can be effectively reduced.

Furthermore, the depth of the interface constituting said barrier may be made shallower than the thickness of said emitter and collector regions, to concentrate the emitter current in the vicinity of the surface of the substrate. Such current concentration close to the surface of the substrate allows to make the active area of the device thinner, thereby responding to the requirements of higher level of integration and finer geometry.

A heterogeneous junction consisting of a mixed crystal layer such as $Si_{1-x}Ge_x$ and a monocrystalline layer such as Si may be formed at the interface of the emitter and base regions to constitute a potential barrier, functioning to prevent the diffusion of emitter current into the interior of the substrate and also preventing increase in recombination current in the base region.

In the following the present invention will be clarified in detail by embodiments thereof shown in the attached drawings.

In the accompanying drawings:

Fig. 1 is a schematic cross-sectional view of a lateral bipolar transistor described hereinbelow as a background example;

Fig. 2A is a schematic view showing the potential distribution along a line A-A' in Fig. 1;

Fig. 2B is a schematic view showing the potential distribution along a line B-B' in Fig. 1;

Fig. 3 is a chart showing the mobility, life and diffusion length of positive holes as a function of concentration of n-type impurity;

Fig. 4 is a chart showing the mobility life and diffusion length of electrons as a function of concentration of p-type impurity;

Fig. 5 is a schematic cross-sectional view of a first embodiment of the present invention;

Fig. 6 is a schematic cross-sectional view of a second embodiment; and

Fig. 7 is a chart showing the change in the band gap as a function of mixed crystal ratio in $Si_{1-x}Ge_x$.

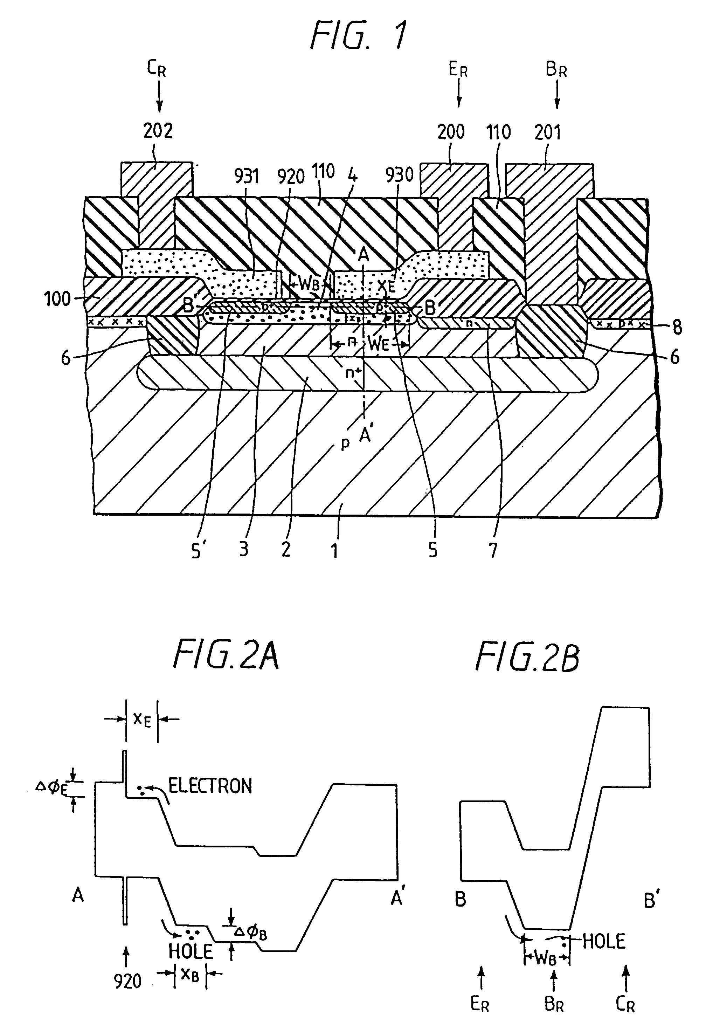

Fig. 1 illustrates a lateral bipolar transistor which is to be discussed hereinbelow by way of background. It is a subject of related European Patent EP-B-0443852 (Application No. 91301383.5).

A silicon substrate 1 is composed of a p-substrate doped with a p-type impurity capable of controlling the conductive type in the p-type, such as boron (B).

An embedded region 2 is doped with an impurity capable of controlling the conductive type, an n-type impurity such as phosphorus (P) with an impurity concentration of $10^{16}$ - $10^{20}$ [cm$^{-3}$].

An n-region 3, constituting a part of the base region $B_R$, is for example formed by epitaxial growth with a low impurity concentration (for example $10^{14}$ - $5 \times 10^{17}$ [cm$^{-3}$]).

An n-region 4, is composed of a mixed crystal $Si_{1-x}Ge_x$ with a narrow energy band gap, and constitutes the base region $B_R$.

P$^+$-regions 5, 5' are formed in said n-region 4 and respectively constitute an emitter region $E_R$ and a collector region $C_R$.

An n$^+$-region 6 connects said embedded region 2 with a metal base electrode 201, in order to reduce the base resistance of the lateral bipolar transistor.

An n-region 7 and a p-region 8 constitute channel stops. An ultra thin tunnel oxide film 920 (for example of a thickness not exceeding 20Å, 1Å = 0.1 nm) serves to pass both electrons and positive holes by tunnel effect.

Polycrystalline semiconductive layers 930, 931 are composed of polycrystalline silicon doped with boron (B) at a high concentration (for example $10^{18}$ - $10^{20}$ [cm$^{-3}$] ).

There are further shown an element separating region 100, an electrode separating insulating region 110, a metal base electrode 201, and a metal collector electrode 202.

Figs. 2A and 2B schematically show the potential distribution of the semiconductor device shown in Fig. 14, respectively, along lines A-A' and B-B' shown therein.

As shown in Fig. 2B, the potential distribution along the line B-B' in Fig. 1 is similar to that in the usual bipolar transistor, and the collector current $I_C$ can be easily calculated as it is determined by the concentration $N_B$ of the base region $B_R$ and the base width $W_B$. In the conventional lateral bipolar transistor, the emitter area and the collector region mutually face only in a very small area, while they are extended quite widely along the surface of the substrate. Consequently a current generated by the positive holes injected from the emitter region $E_R$ into the base region $B_R$ along the direction of depth of substrate and a diffusion current generated by the electrons flowing from the base region to the emitter region predominantly govern the function, and a limitation is posed on the increase of the current amplification factor $h_{FE}$.

In the present example, therefore, a barrier $\Delta\phi_B$ consisting of a heterogeneous interface between the emitter region and a semiconductor layer is formed at a depth $\chi_B$ from said emitter region and, above the emitter region, there are formed a thin tunnel film and a polycrystalline silicon layer 930 of a wider energy band gap than in said emitter region, in order to prevent the diffusion of electrons injected into said emitter region.

In the following the current components in the lateral bipolar transistor will be explained.

(I) Collector current $I_C$:

The collector current $I_C$ between the mutually opposed emitter and collector can be substantially determined by the following equation.

The magnitude of the emitter region opposed to the collector region in a lateral bipolar transistor can be approximately represented by $\chi_E \cdot L$ wherein $\chi_E$ and L are respectively the depth and length of the emitter.

$$I_C = \chi_E \cdot L \cdot \left(\frac{q \cdot D_p \cdot n_i}{N_B \cdot L_p}\right)^2 \text{cosech}\left(\frac{W_B}{L_p}\right)\left[\exp\left(\frac{V_{BE}}{kT}\right)-1\right] \tag{1}$$

wherein q is elementary charge [C], $D_p$ is diffusion coefficient [cm$^2$/s] of positive holes, $L_P$ is diffusion length [cm] of positive holes, $n_i$ is true carrier density [cm$^{-3}$], $V_{BE}$ is emitter-base voltage, $W_B$ is base width [cm], $N_B$ is base impurity concentration [cm$^{-3}$], $T_E$ is emitter depth, L is emitter length, K is Boltzman constant [J/K], and T is absolute temperature [°K].

(II) Base current $I_B$:

The base current $I_B$ is principally composed of three components shown in the following equations (2) - (4).

(a) Recombination current $I_{BI}$ generated in the base area $B_R$ by the positive holes flowing horizontally from the emitter region $E_R$:

$$I_{B1} = \chi_E \cdot L \cdot \left(\frac{q \cdot D_p \cdot n_i^2}{N_B \cdot L_P}\right) \cdot \frac{\cosh(W_B/L_P)-1}{\sinh(W_B/L_p)} \cdot \left[\exp\left(\frac{V_{BE}}{kT}\right)-1\right] \tag{2}$$

(b) Recombination current $I_{B2}$ generated by the positive holes flowing vertically from the emitter region $E_R$:

$$I_{B2} = (W_E \cdot L)\frac{q \cdot n_i^2 \cdot D_p}{N_B \cdot L_p} \cdot \tanh\left(\frac{\chi_B}{L_p}\right) \cdot \left[\exp\left(\frac{V_{BE}}{kT}\right)-1\right] \tag{3}$$

wherein $\chi_B$ is the distance in the direction of depth from the emitter area $E_R$, and $W_E$ is emitter width.

(c) Diffusion current $I_{B3}$ generated by the electrons flowing from the base region $B_R$ to the emitter region $E_R$:

$$I_{B3} = (W_E \cdot L)\frac{q \cdot n_i^2 \cdot D_n}{N_E \cdot L_n} \cdot \tanh\left(\frac{\chi_E}{Ln}\right) \cdot \left[\exp\left(\frac{V_{BE}}{kT}\right)-1\right] \tag{9}$$

wherein $N_E$ is impurity concentration in the emitter region $E_R$, Ln is diffusion length of the electrons, and $D_n$ is diffusion coefficient of the electrons.

In the present example, particular attention is paid to the base current components $I_{B2}$ represented by the equation (3) and $I_{B3}$ represented by (4).

In the conventional lateral bipolar transistor, most of the positive holes injected from the emitter region $E_B$ flows vertically and contributes to the base current by recombination. On the other hand, in the present invention, a potential barrier $\Delta\phi_B$ is formed at a distance $\chi_B$ from the emitter area region $E_R$ to stop the injected carriers.

The probability of passing through said barrier is represented by $\exp(-\Delta\phi_B/kT)$.

Said probability, for example at room temperature is $\Delta\phi_B = 0.1$ [eV], which is about 1/54 of that in the conventional lateral bipolar transistor.

If $\chi_B << L_p$ in the equation (3), since tanh $(\chi_B/L_p) \simeq \chi_B/L_p$, $I_{N2}$ in the lateral bipolar transistor of the present example becomes significantly lower than that in the conventional one.

In the following there will be explained the diffusion lens $L_p$ of positive holes in the n-area.

Following equation stands for the mobility $\mu_p$ of positive holes, over a wide range of the n-impurity concentration $N_D$:

$$\mu_p = \frac{370}{1 + (N_D/8 \times 10^{17})^{1.25}} + 130 \, [\text{cm}^2/\text{V·sec}] \tag{5}$$

As will be understood from this equation (5), the mobility $\mu_p$ approaches a constant value 500 $[\text{cm}^2/\text{V·sec}]$ when the impurity concentration $N_D$ becomes smaller, but becomes a function of said concentration $N_D$ when it exceeds $10^{17}$ $[\text{cm}^{-3}]$.

On the other hand, the life $\tau_p$ of the minority carriers is represented by the following equation when the impurity concentration exceeds $10^{17}$ $[\text{cm}^{-3}]$:

$$\frac{1}{\tau_p} = 7.8 \times 10^{-13} N_D + 1.8 \times 10^{-31} N_D^2 \, [\text{sec}^{-1}] \tag{6}$$

Based on said mobility $\mu_p$ and life $\tau_p$, the diffusion length $L_p$ of positive holes is generally represented by:

$$L_p = \sqrt{\frac{kT}{q} \cdot \mu_p \cdot \tau_p} \tag{7}$$

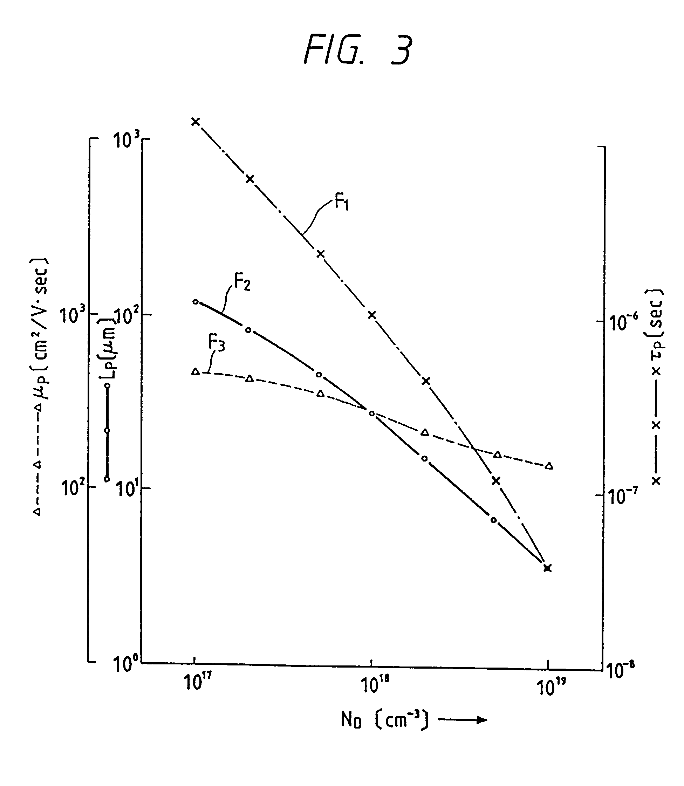

Fig. 3 illustrates the mobility $\mu_p$ (curve $F_3$), life $\tau_p$ (curve $F_1$) and diffusion length Lp (curve $F_2$) of positive holes, constituting the minority carriers in n-type silicon, as calculated from the foregoing equations (5), (6) and (7) in a range of $N_D$ of $10^{17}$ - $10^{19}$ $[\text{cm}^{-3}]$.

As will be apparent from Fig. 3, the diffusion length of positive holes is extremely long and amounts to 120 $[\mu m]$ at $N_D = 10^{17}$ $[\text{cm}^{-3}]$. It is still about 30 $[\mu m]$ even at $N_D = 10^{18}$ $[\text{cm}^{-3}]$.

In a lateral bipolar transistor of pnp type formed on a same substrate together with a usual vertical bipolar transistor of npn type, the impurity concentration of the base region becomes same as that of the collector region of said vertical bipolar transistor npn type and is as low as $10^{14}$ - $5 \times 10^{17}$ $[\text{cm}^{-3}]$, so that the relation $\chi_B << L_p$ can be easily obtained. However a condition of about $\chi_B \leqq L_p/10$ is desirable.

Under such condition, said recombination current $I_{B2}$ is drastically reduced, so that the base current $I_B$ is principally governed by $I_{B1}$ and $I_{B3}$, and the current amplification factor $h_{FE}$ can be made close to that of the vertical bipolar transistor.

With the decrease of said recombination current $I_{B2}$, the base current $I_B$ is predominantly governed by the recombination current $I_{B1}$ and the diffusion current $I_{B3}$, whereas in the conventional lateral bipolar transistor, it is predominantly governed by the diffusion current $I_{B3}$.

Thus, in the present example, above the emitter area, there is provided a polycrystalline layer 930 of a wider energy band gap than in said emitter region as shown in Fig. 2A, thereby preventing the diffusion of electrons.

In the conventional lateral bipolar transistor, said diffusion current $I_{B3}$ is considerably large, because a metal electrode is formed directly above the emitter region 5.

When the electrons are injected from the base area into the emitter area under a condition $W_B << L_n$, the diffusion current $I_{B3}$ is proportional to $W_E/L_n^2$ as will be understood from the equation (4), but, in the conventional lateral bipolar transistor, it is proportional to $l/W_E$. Thus $I_{B3}$ in the lateral bipolar transistor of the present example is smaller, by a ratio of $W_E^2/L_n^2$, than that in the conventional lateral bipolar transistor.

Then there will be explained that diffusion length of electrons in the $p^+$-region 5.

The following relation stands for the mobility $\mu_n$ of electrons, over a wide range of the concentration Na of p-impurity:

$$\mu_n = 232 + \frac{1180}{1 + (Na/8 \times 10^{16})^{0.9}} \, [\text{cm}^2/\text{V·sec}] \tag{10}$$

Consequently the mobility $\mu_n$ approaches to 1412 $[\text{cm}^2/\text{V·sec}]$ for a lower impurity concentration Na, and becomes equal to 232 $[\text{cm}^2/\text{V·sec}]$ for an infinitely high impurity concentration Na.

On the other hand, the life $\tau_n$ of the minority carriers is represented by the following equation for an impurity concentration equal to or larger than $10^{17}$ [cm$^{-3}$]:

$$\frac{1}{\tau_n} = (3.45 \times 10^{-12}\text{Na}) + (9.5 \times 10^{-32}\text{Na}^2) \text{ sec}^{-1} \qquad (11)$$

Based on said mobility $\mu_n$ and life $\tau_n$, the diffusion length $L_n$ is generally represented by:

$$L_n = \sqrt{\frac{kT}{q} \cdot \mu_n \cdot \tau_n} \qquad (12)$$

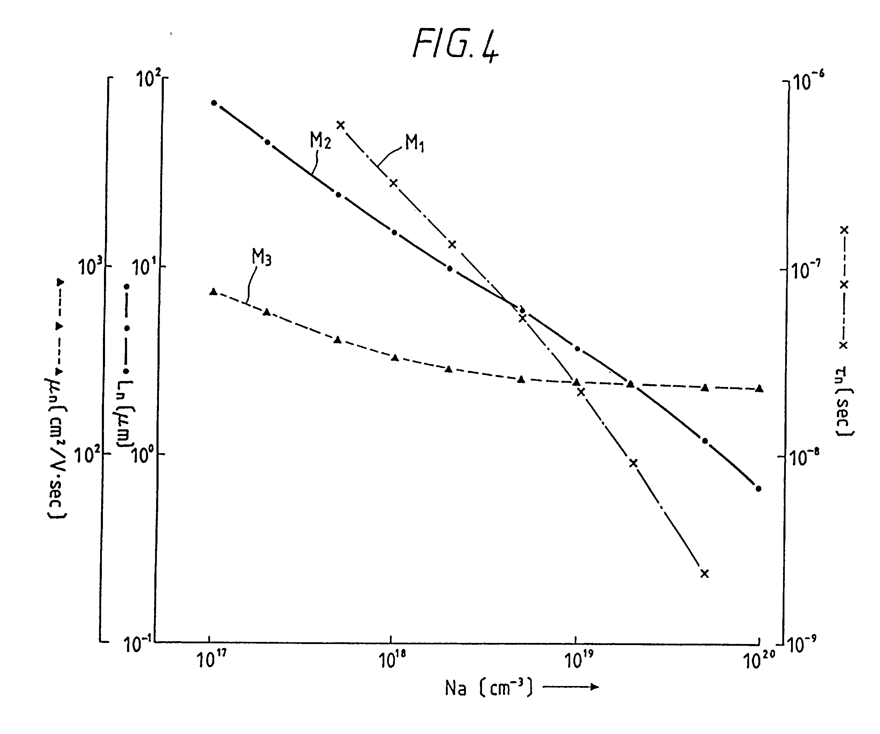

Fig. 4 shows the mobility $\mu_n$ (curve M3), life $\tau_n$ (curve $M_1$) and diffusion length $L_n$ (curve $M_2$) of the electrons, calculated by the equations (10), (11) and (12) in a range of the p-impurity concentration Na of $10^{17}$ - $10^{20}$ [cm$^{-3}$].

From Fig. 4, the following facts will be understood. The p-emitter region of the horizontal bipolar transistor is usually common with the base region of the vertical bipolar transistor and has therefore an impurity concentration not exceeding $10^{18}$ [cm$^{-3}$], and the diffusion length becomes as large as 15 - 70 [µm] in such state. Consequently the diffusion current $I_{B3}$ in the emitter region can be sufficiently lowered if the emitter width $W_E$ is about $L_n/r$ or less.

$Si_{1-x}Ge_x$ constituting said n-region 4 shows a small carrier mobility due to the alloy effect, but, under a high impurity concentration for example equal to higher than $10^{18}$ [cm$^{-3}$], it behaves like Si because the carrier effect by the impurities becomes predominant.

In the structure of the present example,, as explained in the foregoing, the base current approaches the value of the recombination current $I_{B1}$, and the current amplification factor $h_{FE}$ approaches that of a vertical heterogeneous bipolar transistor. The theoretical current amplification factor in such state, if a condition $W_B \ll L_p$ is satisfied, can be represented by:

$$h_{FE} \cong \frac{I_c}{I_{B1}} \cong 2(\frac{L_p}{W_B})^2 \qquad (13)$$

As explained in the foregoing, the present example is designed to block the positive holes, injected from the p$^+$-emitter region 5, by the heterogeneous interface between the n- region 4 and the n-region 3 of mixed crystal, thereby preventing the diffusion of said positive holes into the deeper part of the substrate, and to prevent the diffusion of electrons, injected into the emitter region by the potential barrier formed at the heterogeneous interface between the Si-Ge mixed crystal and the monocrystalline silicon.

In the following there will be explained an example of the manufacturing process of the lateral bipolar transistor shown in Fig. 1:

(I) On a p-type substrate I, an n$^+$-embedded region2 with an impurity concentration for example of $10^{15}$ - $10^{19}$ [cm$^{-3}$] was formed by implantation (or diffusion) of at least an element selected from the elements of group V, such as As, Sb, P etc.

(2) An n-region 3 with an impurity concentration for example of $10^{14}$ - $10^{17}$ [cm$^{-3}$] was formed for example by epitaxial growth.

(3) An n$^+$- region 6 (with an impurity) concentration for example of $10^{17}$ - $10^{20}$ [cm$^{-3}$]) was formed for reducing the base resistance.

(4) An insulating film 100 for element separation was formed by selective oxidation or CVD, and a channel stop region 7 was formed under said insulating film 100.

(5) Ge ions were selectively implanted into the Si substrate I for example with an impurity concentration of 1 x $10^{16}$ - 1 x $10^{17}$ [cm$^{-2}$], and a heat treatment was conducted to form an n-region 4 consisting of $Si_{1-x}Ge_x$.

(6) B$^+$ ions were implanted with a concentration of 1 x $10^{15}$ [cm$^{-2}$], and a heat treatment was conducted to form p$^+$-regions 5,5' constituting the emitter and the collector.

(7) An ultra thin oxide film 920, of a thickness for example not exceeding 20 [Å], was formed by low-temperature oxidation for example at 500 - 650°C.

(8) Polycrystalline silicon layers 930, 931 were deposited for example with a thickness of 4000 [Å], then subjected to boron ion implantation for example with a concentration of 1 x $10^{16}$ [cm$^{-2}$], further subjected to a heat treatment at 800 - 900°C, and were patterned. In case of monocrystalline silicon, epitaxial growth was conducted for example at about 800°C.

(9) An insulation film 110 was deposited and annealed, and contact holes were opened.

(10) Al-Si (1%) for forming the electrodes 200, 201, 202 was deposited by sputtering and was subsequently patterned.

(11) The alloy formation of said Al-Si electrodes was conducted for example for 30 minutes at 450°C, and a passivation film was formed.

The lateral bipolar transistor shown in Fig. 1 was prepared according to the above-explained procedure.

[Embodiment 1]

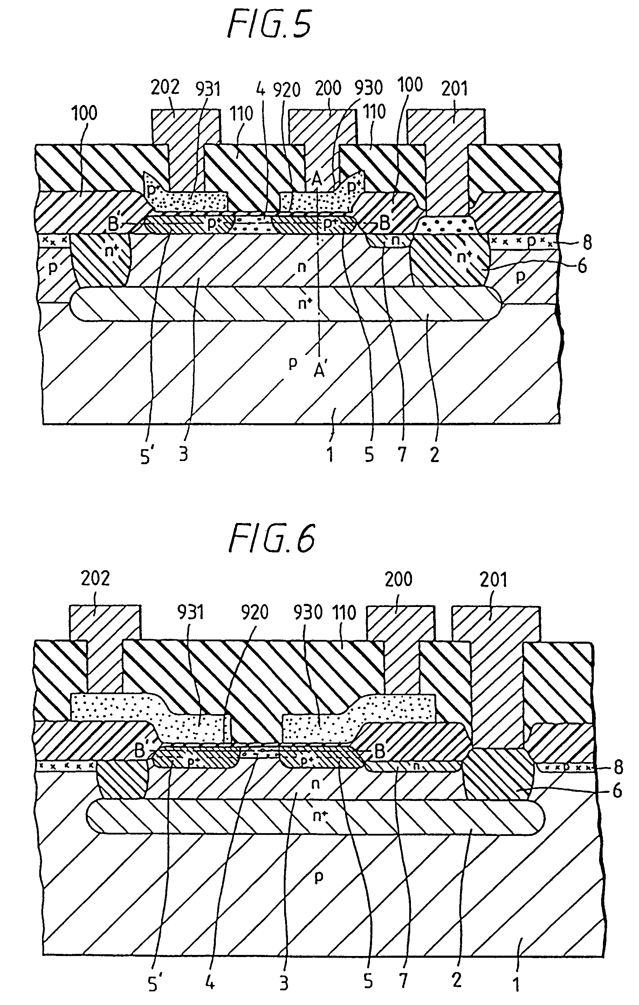

Fig. 5 illustrates a first embodiment of the present invention.

In this first embodiment, the n-region 4 of mixed crystal $Si_{1-x}Ge_x$ is formed not by ion implantation but by epitaxial growth, and $p^+$-regions 5, 5' constituting the emitter and the collector are subsequently formed therein. In this case, the contact of the base region is also formed of the mixed crystal.

Though the foregoing description has been limited to a lateral bipolar transistor of pnp type, the present invention is naturally applicable to a lateral bipolar transistor of npn type. Also there may be employed a heterogeneous junction of mixed crystal of other materials. For example, Si and Si-Ge may be respectively replaced for example by GaAs and GaAlAs, or Inp and InGaPAs.

Other structures and functions are the same as those in the background example and will not therefore be explained further.

[Embodiment 2]

Fig. 6 illustrates a second embodiment.

In this second embodiment, the n-region 4 consisting of $Si_{1-x}Ge_x$ is formed shallower than in the background example. Thus the emitter depth $\chi_B$ is a negative value, and the mixed crystal area consisting of $Si_{1-x}Ge_x$ is shallower than the emitter and collector regions.

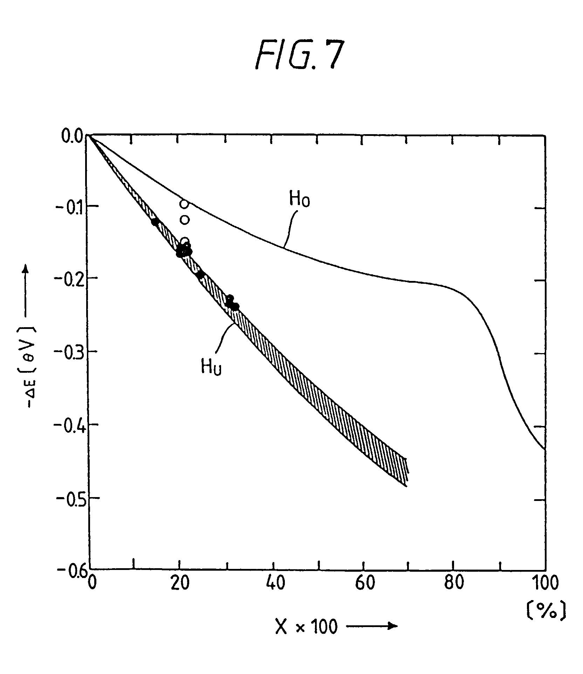

Fig. 7 shows the change in the band gap of the mixed crystal $Si_{1-x}Ge_x$, wherein the abscissa indicates the mixed crystal ratio of Ge ($X \cdot 100\%$) whereas the ordinate indicates decrease $-\Delta E$ in the band gap in comparison with the Si single crystal. A curve $H_o$ indicates a distortion-free state whereas a curve $H_U$ indicates a distorted state, which is selected in a semiconductor device.

As shown in Fig. 7, a band gap decrease $-\Delta E \sim 0.1$ [eV] corresponds approximately to a mixed amount $X = 0.12$, and a barrier of 0.1 [eV] is formed in this state. $X = 0.12$ can be attained for example with a Ge concentration of 6 x $10^{16}$ [cm$^{-3}$].

The p-n junction between said n-region 4 and the $p^+$-region 5 is formed in Si-Ge, while other p-n junctions are formed in Si. As the band gap in Si-Ge is smaller than in Si as shown in Fig. 7, the current for a same applied voltage in the p-n junction in Si-Ge is larger, by exp ($\Delta E/kT$) times, than that in Si, and this difference is about 55 times at room temperature where $\Delta E = 0.1$ eV.

The present embodiment achieves effective function of a lateral bipolar transistor by concentrating the emitter current in the vicinity of the surface of the substrate.

Other structures and functions are similar to those in the foregoing background example and will not, therefore, be explained further.

As explained in detail in the foregoing, the present invention can provide a lateral bipolar transistor which has a high emitter-collector breakdown voltage, is capable of suppressing so-called Early effect, and has a low base current, thereby capable of increasing the current amplification factor $h_{FE}$.

Also the present invention can provide a lateral bipolar transistor excellent in resistance to ambient conditions.

Furthermore, the lateral bipolar transistor of the present invention can be provided inexpensively, since the mass production technology of conventional integrated circuits can be utilised. Furthermore the lateral bipolar transistor of the present invention has a wide field of application, since other elements such as MOS transistors can be integrated therewith.

The foregoing embodiments have been limited to a lateral bipolar transistor of pnp type, but the present invention is naturally applicable to a lateral bipolar transistor of npn type.

In an operation at room temperature, the value x in $Si_{1-x}Ge_x$ is preferably at least equal to 0.03, because $\Delta E$ needs to be at least kT. At room temperature, $kT \sim 25$ meV, so that $\Delta E$ functions as a barrier if x is 0.03 or larger. Also in an operation at the temperature of liquid nitrogen, x is preferably at least equal to 0.008.

## EP 0 642 170 B1

**Claims**

1.  A lateral bipolar transistor comprising:

    an emitter region (5);
    a collector region (5') laterally spaced from and facing said emitter region (5); and
    a base region (3,4) having a buried first portion (3) immediately beneath the underside of said emitter and collector regions (5,5'), and having a second portion (4) located only in-between said emitter region (5) and said collector region (5'), said second portion (4) of said base region (3,4) being immediately adjacent to said buried first portion (3) of said base region (3,4);
    wherein the energy band gap of said second portion (4) of said base region (3,4) is narrower than the energy band gap of said buried first portion (3) of said base region (3,4);
    which lateral bipolar transistor is characterised by:
    an ultra thin film insulating layer (920) for passing a tunnel current, which insulating layer (920) is on the surface of said emitter region (5); and
    a polycrystalline emitter contact layer (930) on said insulating layer (920); wherein
    at the junctions of said contact layer (930), insulating layer (920), and emitter region (5), the energy band gap of said polycrystalline emitter contact layer (930) is wider than the energy band gap of said emitter region (5).

2.  A lateral bipolar transistor according to claim 1 wherein said emitter region (5), said collector region (5') and said second portion (4) of said base region (3,4) are comprised in a common layer the energy band gap of which is narrower than both the energy band gap of said buried first portion (3) of said base region (3,4) and the energy band gap of said polycrystalline emitter contact layer (930).

3.  A lateral bipolar transistor according to claim 2 wherein said common layer is of mixed crystal silicon germanium $Si_{1-x}Ge_x$, said buried first portion (3) of said base region (3,4) is of silicon Si, and said contact layer is of polycrystalline Si.

4.  A lateral bipolar transistor according to claim 3 which said base region (3,4) has a contact region (2,6) comprising an isolated part of said common layer of mixed crystal silicon germanium $Si_{1-x}Ge_x$.

5.  A lateral bipolar transistor according to claim 1, wherein the interface between the first and second portions (3,4) of said base region (3,4) is nearer to the surface of said lateral bipolar transistor than the respective interfaces between said emitter and collector regions (5,5') and said buried first portion (3) of said base region (3,4).

6.  A lateral bipolar transistor according to claim 5, wherein the emitter and collector regions are laminated each having a surface portion and a buried portion, and
    the surface portion of said emitter region (5), the surface portion of said collector region (5'), and said second portion (4) of said base region (3,4) are comprised in a common layer the energy band gap of which is narrower than both the energy band gap of said buried first portion (3) of said base region (3,4) and the energy band gap of said polycrystalline emitter contact layer (930).

7.  A lateral bipolar transistor according to claim 6, wherein said common layer is of mixed crystal silicon germanium $Si_{1-x}Ge_x$, said buried portion of said emitter region (5), said buried portion of said collector region (5'), and said buried first region (3) of said base region (3,4) are of silicon Si, and said polycrystalline emitter contact layer (930) is of polycrystalline Si.

**Patentansprüche**

1.  Lateraler Bipolartransistor mit

    einem Emitterbereich (5),
    einem Kollektorbereich (5'), der seitlich von dem Emitterbereich (5) beabstandet ist und diesem zugewandt ist, und
    einem Basisbereich (3, 4), der einen vergrabenen ersten Abschnitt (3) unmittelbar unter der Unterseite der Emitter- und Kollektorbereiche (5, 5') und einen zweiten Abschnitt (4) aufweist, der lediglich zwischen dem Emitterbereich (5) und dem Kollektorbereich (5') angeordnet ist, wobei der zweite Abschnitt (4) des Basisbe-

8

reichs (3, 4) unmittelbar zu dem ersten vergrabenen Abschnitt (3) des Basisbereichs (3, 4) benachbart ist, wobei die Energiebandlücke des zweiten Abschnitts (4) des Basisbereichs (3, 4) schmaler als die Energiebandlücke des vergrabenen ersten Abschnitts (3) des Basisbereichs (3, 4) ist,

**gekennzeichnet durch**

eine Dünnschichtfilm-Isolierschicht (920) zum Durchlassen eines Tunnelstrom, wobei die Isolierschicht (920) sich auf der Oberfläche des Emitterbereichs (5) befindet, und
eine polykristalline Emitterkontaktschicht (930) auf der Isolierschicht (920), wobei
an den Verbindungen der Kontaktschicht (930), der Isolierschicht (920) und des Emitterbereichs (5) die Energiebandlücke der polykristallinen Emitterkontaktschicht (930) breiter als die Energiebandlücke des Emitterbereichs (5) ist.

2.  Lateraler Bipolartransistor nach Anspruch 1,
    **dadurch gekennzeichnet, daß**
    der Emitterbereich (5), der Kollektorbereich (5') und der zweite Abschnitt (4) des Basisbereichs (3, 4) in einer gemeinsamen Schicht zusammengefaßt sind, deren Energiebandlücke schmaler als sowohl die Energiebandlücke des vergrabenen ersten Abschnitts (3) des Basisbereichs (3, 4) als auch die Energiebandlücke der polykristallinen Emitterkontaktschicht (930) ist.

3.  Lateraler Bipolartransistor nach Anspruch 2,
    **dadurch gekennzeichnet, daß**
    die gemeinsame Schicht aus einem $Si_{1-x}Ge_x$-Silizium-Germanium-Mischkristall besteht, der erste vergrabene Abschnitt (3) des Basisbereichs (3, 4) aus Silizium Si besteht und die Kontaktschicht aus polykristallinen Silizium besteht.

4.  Lateraler Bipolartransistor nach Anspruch 3,
    **dadurch gekennzeichnet, daß**
    dessen Basisbereich (3, 4) einen Kontaktbereich (2, 6) mit einem isolierten Teil der gemeinsamen Schicht aus dem $Si_{1-x}Ge_x$-Silizium-Germanium-Mischkristall aufweist.

5.  Lateraler Bipolartransistor nach Anspruch 1,
    **dadurch gekennzeichnet, daß**
    die Zwischenfläche zwischen den ersten und zweiten Abschnitten (3, 4) des Basisbereichs (3, 4) näher an der Oberfläche des lateralen Bipolartransistors als an den jeweiligen Zwischenflächen zwischen den Emitter und Kollektorbereichen (5, 5') und dem vergrabenen ersten Abschnitt (3) des Basisbereichs (3, 4) liegt.

6.  Lateraler Bipolartransistor nach Anspruch 5,
    **dadurch gekennzeichnet, daß**
    die Emitter- und Kollektorbereiche geschichtet sind sowie jeweils einen Oberflächenabschnitt und einen vergrabenen Abschnitt aufweisen, wobei
    der Oberflächenabschnitt des Emitterbereichs (5), der Oberflächenabschnitt des Kollektorbereichs (5') und der zweite Abschnitt (4) des Basisbereichs (3, 4) in einer gemeinsamen Schicht zusammengefaßt sind, deren Energiebandlücke schmaler als sowohl die Energiebandlücke des vergrabenen Abschnitts (3) des Basisbereichs (3, 4) als auch die Energiebandlücke der polykristallinen Emitterkontaktschicht (930) ist.

7.  Lateraler Bipolartransistor nach Anspruch 6,
    **dadurch gekennzeichnet, daß**
    die gemeinsame Schicht aus dem $Si_{1-x}Ge_x$-Silizium-Germanium-Mischkristall besteht, der vergrabene Abschnitt des Emitterbereichs (5), der vergrabene Abschnitt des Kollektorbereichs (5') und der vergrabene erste Abschnitt (3) des Basisbereichs (3, 4) aus Silizium Si und die polykristalline Emitterkontaktschicht (930) aus polykristallinem Si bestehen.

**Revendications**

1.  Transistor bipolaire latéral comprenant :

une région d'émetteur (5);

une région de collecteur (5') espacée latéralement de la région d'émetteur (5) et faisant face à celle-ci; et

une région de base (3, 4) ayant une première partie enterrée (3) située immédiatement au-dessous de la face inférieure des régions d'émetteur et de collecteur (5, 5'), et ayant une seconde partie (4) située seulement entre la région d'émetteur (5) et la région de collecteur (5'), cette seconde partie (4) de la région de base (3, 4) étant immédiatement adjacente à la première partie enterrée (3) de la région de base (3, 4);

dans lequel la bande d'énergie interdite de la seconde partie (4) de la région de base (3, 4) est plus étroite que la bande d'énergie interdite de la première partie enterrée (3) de la région de base (3, 4);

ce transistor bipolaire latéral étant caractérisé par :

une couche isolante ultra-mince (920) pour le passage d'un courant tunnel, cette couche isolante (920) se trouvant sur la surface de la région d'émetteur (5) ; et

une couche polycristalline de contact d'émetteur (930) sur la couche isolante (920); dans lequel aux jonctions de la couche de contact (930), de la couche isolante (920) et de la région d'émetteur (5), la bande d'énergie interdite de la couche polycristalline de contact d'émetteur (930) est plus large que la bande d'énergie interdite de la région d'émetteur (5).

2. Transistor bipolaire latéral selon la revendication 1, dans lequel la région d'émetteur (5), la région de collecteur (5') et la seconde partie (4) de la région de base (3, 4) sont incorporées dans une couche commune dont la bande d'énergie interdite est plus étroite à la fois que la bande d'énergie interdite de la première partie enterrée (3) de la région de base (3, 4) et que la bande d'énergie interdite de la couche polycristalline de contact d'émetteur (930).

3. Transistor bipolaire latéral selon la revendication 2, dans lequel la couche commune consiste en silicium-germanium à cristaux mélangés, $Si_{1-x}Ge_x$, la première partie enterrée (3) de la région de base (3, 4) consiste en silicium Si, et la couche de contact consiste en Si polycristallin.

4. Transistor bipolaire latéral selon la revendication 3, dans lequel la région de base (3, 4) a une région de contact (2, 6) constituant une partie isolée de la couche commune de silicium-germanium à cristaux mélangés, $Si_{1-x}Ge_x$.

5. Transistor bipolaire latéral selon la revendication 1, dans lequel l'interface entre les première et seconde parties (3, 4) de la région de base (3, 4) est plus proche de la surface du transistor bipolaire latéral que les interfaces respectives entre les régions d'émetteur et de collecteur (5, 5') et la première partie enterrée (3) de la région de base (3, 4).

6. Transistor bipolaire latéral selon la revendication 5, dans lequel les régions d'émetteur et de collecteur sont formées sous la forme de couches ayant chacune une partie de surface et une partie enterrée, et la partie de surface de la région d'émetteur (5), la partie de surface de la région de collecteur (5') et la seconde partie (4) de la région de base (3, 4) sont incorporées dans une couche commune dont la bande d'énergie interdite est plus étroite à la fois que la bande d'énergie interdite de la première partie enterrée (3) de la région de base (3, 4) et que la bande d'énergie interdite de la couche polycristalline de contact d'émetteur (930).

7. Transistor bipolaire latéral selon la revendication 6, dans lequel la couche commune consiste en silicium-germanium à cristaux mélangés, $Si_{1-x}Ge_x$, la partie enterrée de la région d'émetteur (5), la partie enterrée de la région de collecteur (5') et la première région enterrée (3) de la région de base (3, 4) consistent en silicium Si, et la couche polycristalline de contact d'émetteur (930) consiste en Si polycristallin.

## FIG. 1

## FIG.2A

## FIG.2B

# FIG. 3

FIG. 4

EP 0 642 170 B1

# FIG.5

# FIG.6

# FIG.7